# EUROPEAN PATENT SPECIFICATION

(11) **EP 2 556 541 B1**
(45) Date of publication and mention of the grant of the patent: **23.05.2018**
(21) Application number: 11714731.4
(22) Date of filing: 06.04.2011
(51) Int. Cl.: H01L 31/0216, G02B 1/11

(54) **NANOPARTICLE ANTIREFLECTION LAYER**
Nanopartikel-Antireflexbeschichtung
Couche antireflet à nanoparticules

(30) Priority: 06.04.2010 EP 10159174
(43) Date of publication of application: 13.02.2013
(73) Proprietor: Stichting Energieonderzoek Centrum Nederland, 1755 LE Petten (NL)
(72) Inventor: DE WAELE, Rene, NL-3038 AA Rotterdam (NL); HEBBINK, Maarten, NL-7021 KC Zelhem (NL); POLMAN, Albert, NL-1019 AX Amsterdam (NL)
(74) Representative: Nederlandsch Octrooibureau
(86) International application number: PCT/EP2011/055323
(87) International publication number: WO 2011/124594

(56) References cited:
- US-A1- 2006 007 791
- US-A1- 2008 171 192
- PILLAI S ET AL: "Surface plasmon enhanced silicon solar cells", JOURNAL OF APPLIED PHYSICS, AMERICAN INSTITUTE OF PHYSICS. NEW YORK, US LNKD- DOI:10.1063/1.2734885, vol. 101, no. 9, 7 May 2007 (2007-05-07), pages 93105-093105, XP012098459, ISSN: 0021-8979
- YI LOU ET AL: "Fabrication of Nanoshell Arrays Using Directed Assembly of Nanospheres", IEEE SENSORS JOURNAL, IEEE SERVICE CENTER, NEW YORK, NY, US LNKD- DOI:10.1109/JSEN.2009.2038586, vol. 10, no. 3, 1 March 2010 (2010-03-01), pages 617-620, XP011290001, ISSN: 1530-437X

## Description

### Field of the invention

The invention relates to a nanoparticle antireflection layer and, in particular, though not necessarily, to a nanoparticle thin-film broadband antireflection layer, to optical elements and optoelectronic devices comprising such antireflection layer and to the use of such nanoparticles in an antireflection layer.

### Background of the invention

Antireflection (AR) coatings (layers) are well known optical coatings used in optical devices or elements in order to reduce reflection of light. The use of such AR coatings cover a wide range of important optical applications including AR coatings for optical elements, e.g. lenses, and optoelectronic devices, e.g. solar cells, light emitting diodes, lasers, and displays. Conventional AR coatings are based on interference effects in one or more dielectric layers of a specific thickness and refractive index. A single layer AR coating is inherently unable to reduce reflection over a broad range of wavelengths. This is particularly important in solar cells that convert the broad spectral range emitted by the sun to electricity. Moreover such conventional AR coatings suffer from undesired angle dependences.

In order to solve this problem typically multilayer graded-index AR coatings are used. For example, Chhajed et al. describe in their article "Nanostructured multilayer graded-index antireflection coating for Si solar cells with broadband and omnidirectional characteristics" (Applied Physics Letters 93, 251108 (2008)) the use of multilayer graded-index AR coatings comprising a low refractive index nanostructured porous silicon dioxide top layer. Other ways of achieving graded index antireflection coatings are described in US7,170,666, which describes a method for etching nanostructures into a thin film oxide layer thereby realizing a graded index oxide surface. Such broadband graded index multilayer antireflection coatings however require tight control of process parameters, e.g. the layer thicknesses and layer compositions, and are thus not suitable for implementation in mass produced optical devices and elements.

US2008/0171192 suggests the use of a nanoparticle array of relatively small size and pitch for use as an AR layer in the visible range (400-800 nm). For particular applications however, such as solar cell applications, extreme broadband AR coatings are desired which provide optimal transmission of the whole solar spectrum, including UV, visible, near infrared and infrared radiation.

Hence, there is a need in the art for providing improved AR coatings, which provide effective broadband antireflection properties over a wide range of incident angles. Moreover, there is a need in the art for broadband AC coatings, which are simple to fabricate.

### Summary of the invention

It is an object of the invention to reduce or eliminate at least one of the drawbacks in the prior art. In one aspect, the invention may relate to a thin-film broadband antireflection layer for use with an optical element or an optoelectronic device, wherein said antireflection layer comprises: at least one thin-film dielectric layer; and, at least one array of nanoparticles disposed onto or in said thin-film dielectric layer, wherein the dielectric constants of said nano-particles is substantially distinct from the dielectric constant of said dielectric layer. Such nanoparticle antireflection layer provides improved antireflective properties over a broad range of wavelengths, including the UV and IR spectrum range.

In one embodiment, the thickness of the antireflection layer, the size of the nanoparticles in the nanoparticle array and the pitch of the nanoparticle array is selected such that transmittance of photons associated with the solar spectrum between 300 and 1100 nm is more than 80%, preferably more than 85%.

In one embodiment said thin-film dielectric layer may comprise silicon dioxide, silicon nitride, tetra-ethylorthosilicate(TEOS), a organic resin, a polymer, a semiconducting layer and/or combinations thereof.

In one embodiment said thin-film dielectric may have a thickness approximately between 10 and 300 nm, preferably between 50 and 100 nm. According to the invention, the average dimensions of said nanoparticles are selected between approximately 100 and 300 nm and wherein the average distance between said particles is selected between 200 and 700 nm. Furthermore at least part of said nanoparticles are metal nanoparticles. In yet a further embodiment said metal may be selected from the group of Au, Ag, Cu, Al and/or alloys thereof.

In one variant at least part of said nanoparticles may be semiconducting nanoparticles. In another variant said semiconducting material may be selected from the group IV semiconductors, the III-V or II-VI semiconducting compounds and/or combinations thereof.

In a further variant, at least part of said nanoparticles may be metaloxide nanoparticles. In yet a further variant said metaloxide may relate to high-refractive index oxides selected from the group of Al2O3, Ta2O5, Ti3O5, TiO2, ZiO2, Nb2O5, CeO2 and Si3N4.

In one embodiment at least part of said nanoparticles has a substantially spheroidal shape; in another embodiment at least part of said nanoparticles are substantially cylindrically shaped.

In a further aspect, the invention may relate to a multilayer structure comprising at least one antireflection layer according to any of the embodiments and/or variants as described above.

In other aspects the invention may relate to an optical element, preferably an optical lens or a display screen, comprising an antireflection layer according to any of the embodiments and/or variants as described above or to an optoelectronic device, preferably a light-receiving or a light-emitting device, comprising an antireflection layer according to any of the embodiments and/or variants as described above.

In one embodiment said antireflection layer is deposited onto a thin-film light absorbing or light-emitting layer associated with an optoelectronic device.

In yet a further aspect, the invention relates to the use of an array of metallic nanoparticles, as at least part of an antireflective coating. According to the invention, the average dimensions of said used nanoparticles are selected between approximately 100 and 300 nm and wherein the average distance between said particles is selected between 200 and 700 nm. In another embodiment, at least part of said used nanoparticles may be metal nanoparticles, preferably said metal being selected from the group of Au, Ag, Cu, Al and/or alloys thereof; and/or, wherein at least part of said used nanoparticles may be semiconducting nanoparticles, preferably said semiconducting material being selected from the group IV semiconductors, the III-V or II-VI semiconducting compounds and/or combinations thereof; and/or wherein at least part of said used nanoparticles may be metaloxide nanoparticles, preferably high-refractive index oxides selected from the group of Ta2O5, Ti3O5, TiO2, ZiO2, Nb2O5, CeO2 and Si3N4.

The invention will be further illustrated with reference to the attached drawings, which schematically show embodiments according to the invention and exemplary devices. It will be understood that the invention is not in any way restricted to these specific embodiments.

### Brief description of the drawings

**Fig. 1** illustrates the transmittance of light into a silicon substrate covered with a nanoparticle AR coating according to one embodiment of the invention.
**Fig. 2** depicts the enhancement factor as a function of the Ag nanoparticle height and the thickness of the Si3N4 spacer layer for a nanoparticle AR coating according to one embodiment of the invention.
**Fig. 3** depicts the enhancement factor as a function of (a) the particle height and (b) thin-film dielectric layer for various other embodiments of the invention.
**Fig. 4A** and **4B** depict the enhancement factor as a function of various parameters associated with the nanoparticle AR coating according to an exemplary device (fig. 4A) and an embodiment (fig. 4B) of the invention.
**Fig. 5** depicts the enhancement factor as a function of the shape of the nanoparticles.
**Fig. 6** depicts the transmittance of light into a silicon substrate covered with a nanoparticle AR coating according to yet another embodiment of the invention.
**Fig. 7** depicts the combined antireflection effect of a dielectric layer and a nanoparticle layer according to one embodiment of the invention.
**Fig. 8** depicts the combined antireflection effect of a dielectric layer and a nanoparticle layer according to another embodiment of the invention.

### Detailed description

In contrast with conventional AR coatings, which are designed to match the refractive index of air with the refractive index of the optical element or optoelectronic device using a stack of dielectrics having a low refractive top dielectric layer and a relatively high refractive index bottom dielectric layer, the present invention uses an array of nanoparticles provided onto the surface or embedded into the surface of a thin-film dielectric.

Further, the use of metals in antireflection coatings is uncommon, as metal films are know as good reflectors. In the present invention the nanostructure of the metal particles, and their assembly in regular arrays or random geometries, leads to efficient anti-reflective properties.

In particular, the present invention uses the scattering properties of light, which depend on the optical constants of the nanoparticles, the optical constants of the surrounding dielectric and the optical constants of the substrate. Light is preferentially scattered by the nanoparticles into the high-refractive index substrate material, thereby rendering the metal nanoparticle arrays effective anti-reflective coatings. A further advantage of this invention for applications for example in solar cells is that the scattered light acquires an angular spread in the substrate, which can lead to more effectively absorption of light in the solar cell. This is a particularly important advantage for thin-film solar cells.

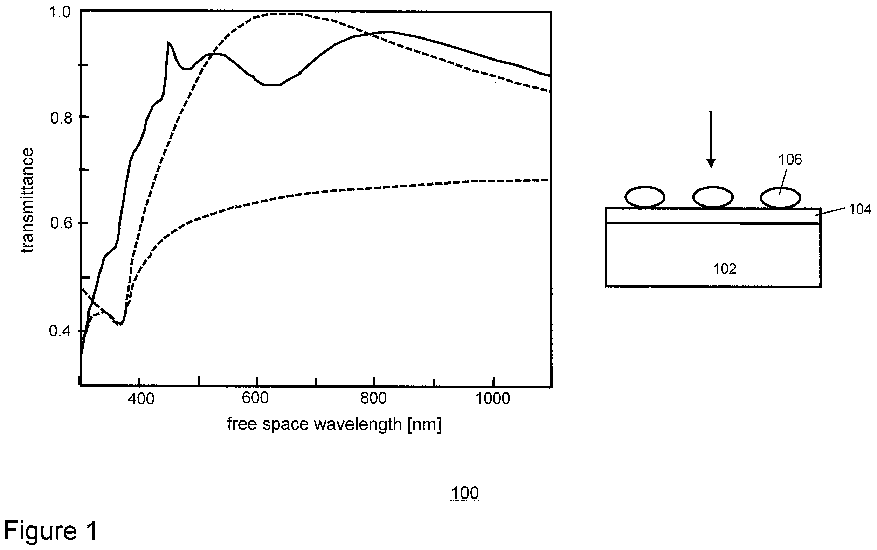

**Fig. 1** illustrates the transmittance of light through a nano-particle AR coating according to one embodiment of the invention. In particular, the example used in **Fig. 1** relates to a crystalline Silicon (c-Si) substrate **102** comprising a 50 nm thin-film Si3N4 dielectric layer **104** on which an array of Ag nano-particles **106** is deposited. The particle dimensions are approximately 200 nm wide by 175 nm high and array pitch in this example is approximately 450 nm. The transmittance light into the substrate of the nanoparticle AR coating is compared with the transmittance of a bare Silicon substrate and a Silicon substrate (n ∼ 3,92) covered with a conventional 80 nm thick Si3N4 AR coating (n ∼ 2.05). The spectral range in **Fig. 1** corresponds to the wavelength range at which sunlight is typically absorbed in a solar cell. While a bare c-Si substrate has a transmittance ranging from 0.4 - 0.65, the nanoparticle coated c-Si substrate shows much higher transmittance, especially in the UV and infrared (IR) range. This is of particular relevance for Si-based solar cells, which are especially sensitive to IR radiation.

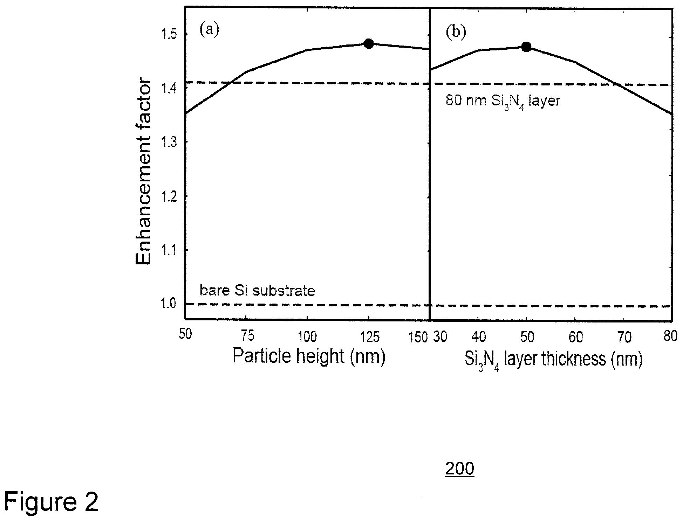

Although the effect at 650 nm is not so high as for a standard AR coating, the total enhancement is larger due to the broadband effect provided by the nanoparticles. This is illustrated in more detail in **Fig. 2****,** which depicts the total enhancement (i.e. a spectrum such as in **Fig. 1** integrated over the whole AM1.5 solar spectrum from 300 to 1100 nm) of light transmitted into the Silicon substrate due to the presence of a nanoparticle AR coating as a function of the particle height. In this example, silver nanoparticles are placed on a 50 nm thick Si3N4 (spacer) layer and the silver particles have an ellipsoidal shape. Data for a bare Silicon substrate and a Silicon substrate covered with a 80 nm thick Si3N4 AR coating are provided as a reference.

**Fig. 2(a)** and **(b)** depict the enhancement factor for different particle parameters. These figures show that the nanoparticle thin-film AR coating allows improved AR properties, in particular a more than 8% improvement, when compared with the conventional Si3N4 AR coating. The improvement in the AR effect is dependent on various parameters, including e.g. particle height (**Fig. 2(a)**) and spacer layer thickness (**Fig**. **2(b)**). Substantial improvement in the broadband AR effect is achieved for nanoparticles having a height of at least 75 nm, preferably 100 nm or more. Similarly, substantial improvement in the broadband AR effect is achieved for Si3N4 spacer layers of thicknesses between 30 and 70 nm, preferably between 35 and 65 nm, more preferably between 40 and 60 nm.

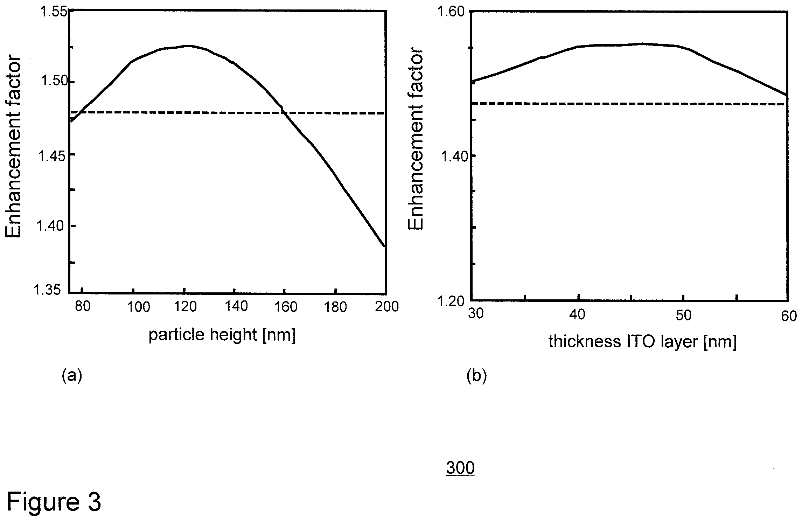

**Fig. 3(a)** and **(b)** depict the enhancement factor for a particle thin-film AR coating according to another embodiment of the invention. **Fig 3(a)** depicts an embodiment wherein the enhancement factor is measured for a nanoparticle AR coating on top of amorphous Silicon (a-Si) as a function of particle height. In this example, the nanoparticle AR coating comprises cylindrical Ag particles of approximately 200 nm width and an array pitch of approximately 450 nm placed on a 50 nm thick Si3N4 thin-film dielectric. **Fig. 3(a)** indicates that for these parameters, in particular for particles of 200 nm width and having a height in a range between approximately 100 and 150 nm, the enhancement factor for cylindrical particles is similar to spheroidal particles as described with reference to **Fig. 2****.** This may be explained by to the fact that for these particular parameters the light coupling is particularly enhanced at the part of the spectrum where a-Si absorbs light better than c-Si.

**Fig. 3(b)** depicts an embodiment wherein the enhancement factor is measured for a nanoparticle AR coating as a function of the thin-film dielectric layer, in this case a thin-film Indium Tin Oxide (ITO) layer, i.e. a transparent conducting layer (TCO), on top of an a-Si substrate. In this example Ag spheroids of 200 nm width and 125 nm height and an array pitch of approximately 450 nm were used. Such nanoparticle AR coating may be advantageously used in a photovoltaic cell based on a-Si. From this figure it follows that a substantial enhancement factor is present over a wide range of ITO thicknesses, in this case between approximately 20 and 60 nm, preferably between 30 nm and 55 nm, more preferably between 35 and 50 nm.

Hence, the inventors have discovered that combining a thin-film dielectric layer with nanoparticles comprising a material having a dielectric constant distinctly different than that of their surrounding forms a very simple and effective broadband AR coating. The present invention is based on the insight that such nanoparticles may be used as strong light scatters. For example, for metallic nanoparticles, e.g. Ag or Au nanoparticles of sufficiently large size, there is almost no absorption in the particles and the scattering cross section may well exceed the particle's geometrical cross section. Such particles may thus be used as effective light scatters requiring a relatively small surface coverage. Depending on particle size, such optimized coverage may be in the order of approximately 10-20% of the surface area.

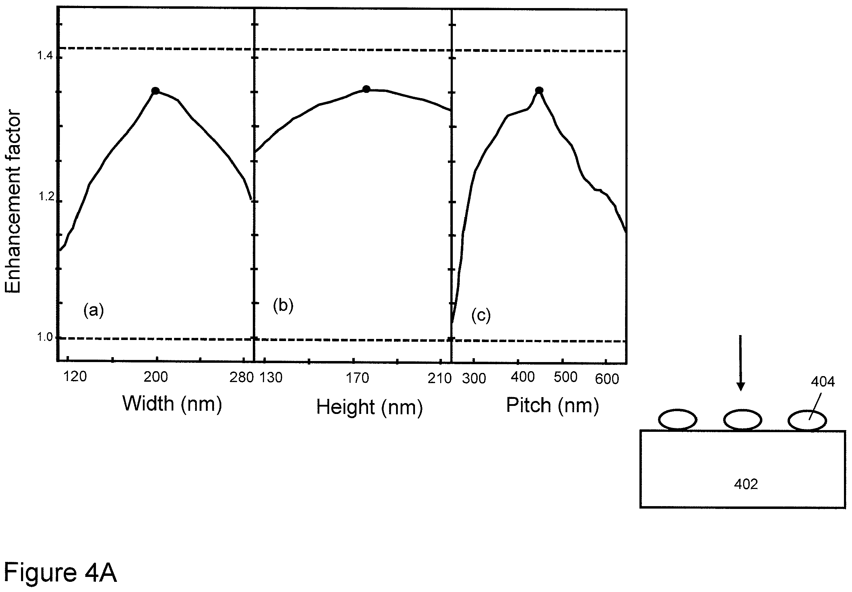

Due to the presence of an array of nanoparticles on top of a substrate having a higher dielectric index than air, light scattered by the nanoparticles will preferentially scatter into the substrate. **Fig. 4A** illustrates in a non embodiment the enhancement of light transmitted into a crystalline substrate **402** due to presence of metallic nanoparticles **404** directly placed on the surface of a silicon substrate for various nanoparticle array configurations. The (maximum) enhancement factor associated with a conventional 80 nm thick Si3N4 AR coating and the enhancement factor for a bare c-Si substrate are added as a reference. In these data, the enhancement is calculated by performing a weighted average of the enhancement over the solar spectrum, limited to wavelengths below the band gap of c-Si.

From **Fig. 4A** it may be derived that a nanoparticle array comprising nanoparticles having a particle width within the range between 160 and 280 nm and/or a particle height between 130 and 220 nm. Further, **Fig. 4A** indicates a strong dependence of the enhancement factor on the array pitch within the range between 300 and 600 nm effectively enhances transmission of light into the substrate when compared to the bare c-Si reference. In particular, for pitches larger than 300 nm, in particular pitches in the range between 350 and 500 nm, preferably between 400 and 500 nm a strong increase of the enhancement factor is determined. Maximum enhancement of approximately 1,35 is achieved of particles of approximately 200 by 175 nm arranged in an array having a pitch of approximately 450 nm.

Further, from **Fig. 4A** it may be generally understood that if the particles (i.e. the particle widths or heights) are too small, the fraction of light interacting with the particle that scatters into the substrate is high, but the scattering efficiency is very low and the absorption in the particles may be relatively high. If, on the contrary, particles are too large, the scattering efficiency is large, but only a relatively small part of the scattered light goes into the substrate. For the particle height, similar reasons may apply as with the particle width. Further, if the pitch is low, the surface coverage will become high and the particle layer effectively becomes a (semi)continuous layer which for example in case of metal nanoparticles may become a metallic reflecting layer or for example in case of dielectric nanoparticles may become a dielectric layer producing classical interference effects.

One of the advantageous of using metal nanoparticles in the formation of a nanoparticle AR coating on e.g. a solar cell, is that metals (e.g. Ag or Al) are used for the formation of the electrical top contact of the solar cell. In this way deposition of electrical contacts and a nanoparticle AR coating may be realized in a single processing step using the same metal. In some embodiments, it is found that the transmittance of light is improved by placing the nanoparticles on a thin dielectric spacer layer on the substrate. Such spacer layers may e.g. be the thin passivation layer that is already present in a standard semiconductor manufacturing process.

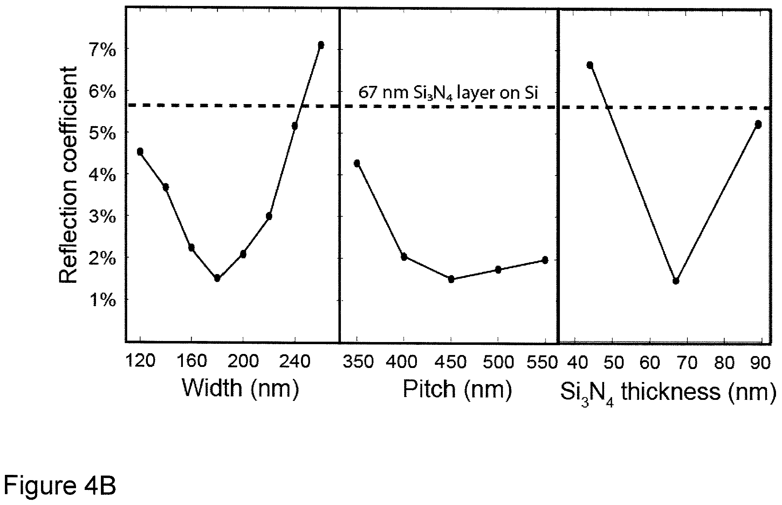

**Fig. 4B** shows the reduction in the measured reflection of a crystalline Silicon (c-Si) substrate due to the presence of silver nanoparticles placed on top of a Si3N4 layer, for various nanoparticle array geometries and different spacer layer thicknesses. The reflection coefficient associate with a 67 nm thick Si3N4 coating is also shown for reference (dashed line).

The reflection coefficients shown in this figure are calculated by averaging the measured reflectivity over the solar spectrum, for wavelengths up to the band gap of c-Si. The graph shows that selection of both the particle array geometry and the Si3N4 spacer layer may be used to minimize reflection, due to the strong coupling between the particles and Si3N4 spacer layer properties. **Fig. 4B** shows that reflection is effectively reduced for particular nanoparticle array geometries, pitches and spacer thicknesses. In particular, reflection is reduced when the particle width is selected from a range between 120 and 240 nm, preferably between 130 nm and 230 nm. Reflection may also be reduced by selecting an array pitch in the range between 350 and 550 nm, preferably 400 nm and 550 nm. In addition **Fig. 4B** also illustrates that the reflection coefficient is also strongly influenced by the thickness of the spacer layer. In particular, by selecting the Si3N4 spacer thickness in the range between 50 and 90 nm, preferably between 55 and 80 nm, a significant reduction in the reflection is obtained.

As will be described in more detail hereunder, the nanoparticle AR coating according to the invention is not limited to the materials as described with reference to **Fig. 1-4B** and may be applied in various combinations without departing from the invention. These variants and the advantages associated with the invention will be discussed hereunder in more detail.

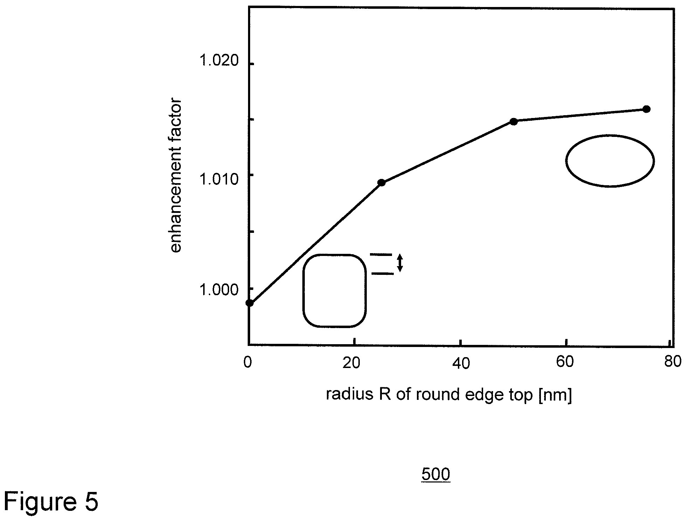

**Fig. 5** illustrates the influence of shape of the nanoparticles used in the nanoparticle AR coating. In particular, this figure illustrates the change in the enhancement factor (calculated for a single particle over a certain area of c-Si) when the particle shape is changed from a cylinder to a spheroid, while keeping the particle width and volume approximately constant. From this figure it may be derived that in some geometries spheroidal particles may provide better AR properties than cylindrical particles.

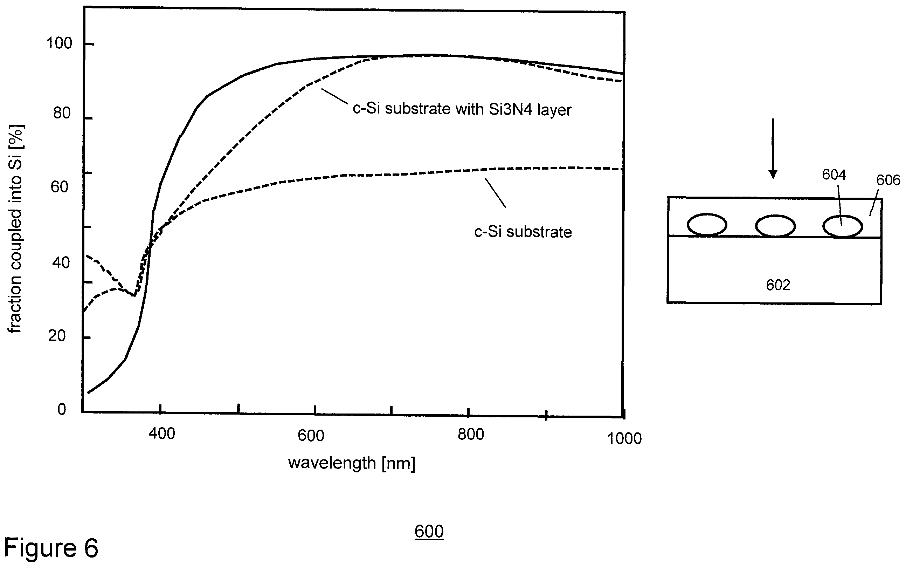

**Fig. 6** depicts yet another embodiment wherein semiconducting nanoparticles are used in the nanoparticle AR coating. In this embodiment, an array of spheroidal Si nanoparticles is disposed on a c-Si substrate. The array of nanoparticles of approximately 160 nm width and 50 nm height has an array pitch of approximately 200 nm. Over the substrate and the array a 120 nm a thin-film dielectric (n=1.5) is deposited, so that the Si nanoparticles are embedded in the thin-film dielectric.

In **Fig. 6** can be seen that a Si nanoparticle AR coating provides the same enhancement as a conventional Si3N4 coating of 80 nm for the red part of the solar spectrum, but enhances coupling of light into the substrate in the blue part above 370 nm. Hence, the results in **Fig. 6** indicate that also non-metallic nanoparticles with a high dielectric constant such as semiconducting nanoparticles, e.g. Si, or insulating nanoparticles, e.g. nanoparticles from high refractive metal oxides such as Al2O3, Ta2O5, Ti3O5, TiO2, ZiO2, Nb2O5, CeO2 and Si3N4 may be used as strong light scatters for use in a nanoparticle AR coating according to the invention. In this embodiment, the Si nanoparticles are embedded in the thin-film dielectric layer thereby providing the advantage that the Si nanoparticles are prevented from being oxidized. The thin-film dielectric layer thus additionally functions as a passivation layer for the nanoparticles. Moreover, such thin-film dielectric layer comprising embedded nanoparticles provides mechanical robustness.

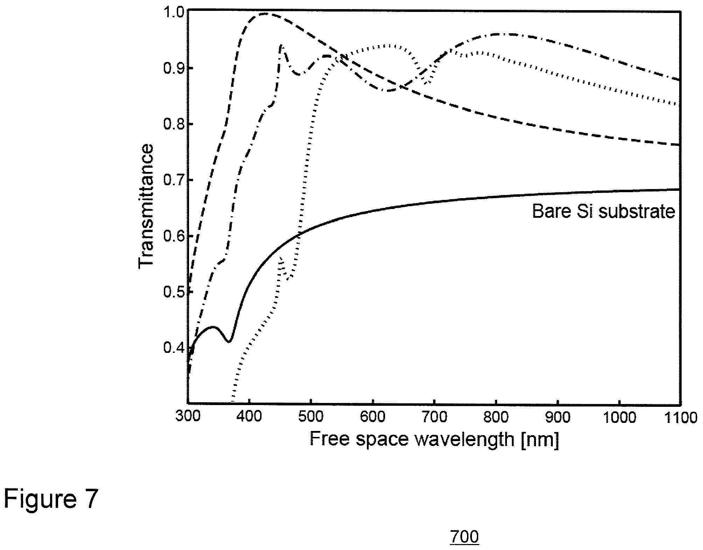

**Fig. 7** depicts the combined antireflection effect of a dielectric layer and a nanoparticle layer according to one embodiment of the invention. In particular, it depicts the transmittance spectrum for a bare Si substrate (solid line), a Silicon substrate comprising a 50 nm thick Si3N4 coating (dashed line), a Silicon substrate comprising a nanoparticle AR layer comprising 200 nm wide and 175 nm high spheroidal silver particles arranged in a square array with 450 nm pitch (dotted line), and a Silicon substrate comprising a 50 nm thick Si3N4 spacer layer and a nanoparticle AR layer comprising approximately 200 nm wide and 125 nm high spheroidal silver nanoparticles arranged in a square array with a 450 nm pitch on top of the spacer layer (dash-dotted line).

From these graphs it can be derived that due to the interaction between the dielectric spacer layer and the nanoparticle AR layer, the dielectric spacer layer especially improves the transmission of light in the UV and visible part of the spectrum, while the nanoparticle AR layer comprising nanoparticles having a dielectric constant substantially distinct from the dielectric constant of the dielectric layer improves transmission in the near IR and IR spectral range. Combination of these AR layers provides significant broadband transmission enhancement over the entire solar spectrum.

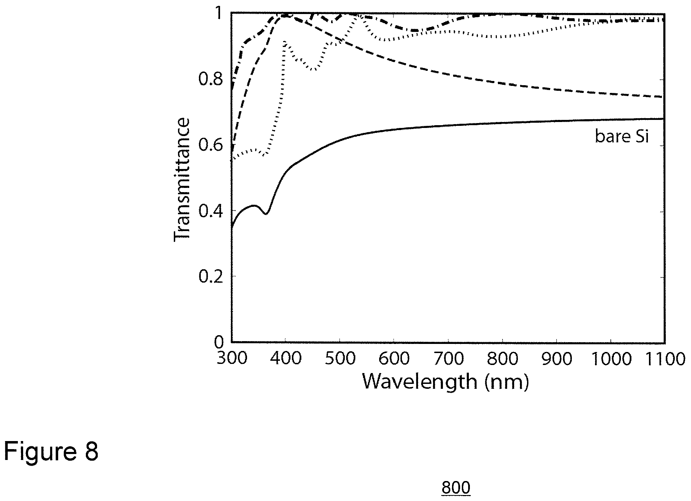

**Fig. 8** depicts the combined antireflection effect of a dielectric layer and a nanoparticle layer according to a further embodiment of the invention. In particular, it depicts the transmittance spectrum for a bare Si substrate (solid line), **a** Silicon substrate comprising 45 nm thick Si3N4 coating (dashed line), a Silicon substrate comprising a nanoparticle coating comprising 250 nm wide and 150 nm high cylindrical silicon particles arranged in a square array with 400 nm pitch (dotted line), and a Silicon substrate comprising a 45 nm thick Si3N4 spacer layer and a nanoparticle AR layer comprising 250 nm wide and 150 nm high cylindrical silver nanoparticles in a square array with 450 nm pitch arranged on top of the spacer layer (dash-dotted line).

This embodiment also illustrates that the broadband enhancement in the transmittance spectrum stems from the combined effect of the nanoparticle layer improving the transmittance in the near IR and IR spectral range and of the dielectric AR layer improving the transmittance in the blue and visible parts of the spectrum wherein the nanoparticles have a dielectric constant which is substantially distinct from the dielectric constant ε of the dielectric layer.

Values of the dielectric constant of the materials used in the nanoparticle AR coatings according to the invention are well known in the art e.g.: polymers ε ∼ 1.4; SiO2 ε ∼ 2.15; Si3N4 ε ∼ 4; TiO2 ε ∼ 7.5; Si ε ∼ 12.25 (1100 nm wavelength) and ε ∼ 15 (500 nm). Further, it is well known in the art that the dielectric constant of metals are complex, wavelength-dependent functions, e.g. for Ag the real part of ε may vary between -55 (1100 nm) and 2 (300 nm) and the imaginary part of ε may vary between 0.5 and 3.5 and for Au the real part of ε may vary between -60 (1100 nm) and 0 (300 nm) and the imaginary part of ε may vary between 1 and 7. A stronger scattering effects requires a larger difference between the dielectric constant of the materials used for the spacer layer and the nanoparticles.

In a further embodiments metal nanoparticles as described with reference to **Fig. 1-5** may be embedded in the thin-film dielectric layer. For example Ag nanoparticles of 200 nm width and 125 nm height and an array pitch of 450 nm may be embedded in a 225 nm thick Si3N4 dielectric. That way, the Ag nanoparticles are prevented from being oxidized.

The materials and AR coating structures used in the embodiments described with reference to **Fig. 1-8** are only for illustration and in no way limiting the invention. For example, typical substrates, which may be coated with a nanoparticle AR coating according to the invention may generally relate to any kind of transparent glass-type substrates for use in optical elements and display device. Other foreseen substrates include semiconducting substrates used in optoelectronic devices such as photovoltaic devices, including amorphous or a (poly)crystalline semiconductor substrates, wherein the semiconductor may be selected from the group consisting of silicon, GaAs and related III-V compounds, CdTe, Cu(In,Ga)(Se,S) CdSe, PbS, PbSe, engineered materials e.g. a quantum dot superlattice or any other semiconductor materials. Further, organic-type optical elements and optoelectrionic devices are also foreseen.

Moreover, it is submitted that the nanoparticle AR coating may be part of a multilayered structure comprising e.g. one or more passivation layers deposited on top of the nanoparticles. Such passivation layer may for example comprise a UV curable resin well known in the art. Further, an array of nanoparticles may both include two-dimensional arrangements with a predetermined pitch and random arrangements of nanoparticles. In such randomized arrangements instead of the array pitch the effective surface coverage (% per unit of area) may be used as one of the parameters defining the nanoparticle AR coating.

The nanoparticle AR coating may be fabricated using various known lithography techniques such as UV, X-ray, e-beam lithography and other related techniques in combination with known thin-film deposition methods such as for example sputtering, thermal evaporation, chemical vapour deposition or sol-gel techniques.

Further, an adapted screen-print or inkjet printing technique may be used which allowing direct printing of nano-sized metal structures (see e.g. Zhao et al., "Self-aligned inkjet printing of highly conducting gold electrodes with submicron resolution", Journal of Applied Physics 101, 064513, 2007).

One particular useful technique for large area application is the imprint lithography technique. One embodiment of this technique is for example described in US patent application US2008/0011934. Using this method an imprint template corresponding to the pattern of a predetermined nanoparticle array with typical dimensions as described in relation with **Fig. 1-8** is made. The structure of the imprint template is transferred to a curable resin layer, which is disposed over the semiconductor layer of the photovoltaic cell. After curing the resin the patterned resist layer is etched in order to expose the surface of the semiconductor layer. Deposition of a metal layer over the imprinted resist pattern, followed by a lift-off finalizes the realization of the contact structure.

It is to be understood that any feature described in relation to any one embodiment may be used alone, or in combination with other features described, and may also be used in combination with one or more features of any other of the embodiments, or any combination of any other of the embodiments. Moreover, the invention is not limited to the embodiments described above, which may be varied within the scope of the accompanying claims.

## Claims

1. A thin-film broadband antireflection layer for use with an optical element or an optoelectronic device, comprising:
at least a thin-film dielectric spacer layer arranged on a substrate;
at least one array of nanoparticles disposed on said thin-film dielectric spacer layer, the dielectric spacer layer being interposed between the at least one array of nanoparticles and the substrate, wherein the dielectric constant of said nanoparticles is substantially distinct from distinct from the dielectric constant of said dielectric spacer layer,
wherein at least part of said nanoparticles are metallic nanoparticles, and
wherein the average dimensions of said nanoparticles are selected between approximately 100 and 300 nm and wherein the average distance between said particles is selected between approximately 200 and 700 nm such that a surface coverage is provided between 10-20% of a surface area of the antireflection layer.

2. Antireflection layer according to claim 1, wherein said thin-film dielectric spacer layer comprises silicon dioxide, silicon nitride, tetra-ethylorthosilicate (TEOS), an organic resin, polymer, a semiconductor and/or combinations thereof.

3. Antireflection layer according to claims 1 or 2, wherein said thin-film dielectric spacer layer has a thickness approximately between 10 and 300 nm, preferably between 50 and 100 nm.

4. Antireflection layer according to any of claims 1-3, wherein the metallic nanoparticles comprise a metal being selected from the group of Au, Ag, Cu, Al and/or alloys thereof.

5. Antireflection layer according to any of claims 1-3, wherein at least part of said nanoparticles are semiconducting nanoparticles, preferably said semiconducting material being selected from the group IV semiconductors, the III-V or II-VI semiconducting compounds and/or combinations thereof.

6. Antireflection layer according to any of claims 1-3, wherein at least part of said nanoparticles are metal oxide nanoparticles, preferably high-refractive index oxides selected from the group of Al2O3, Ta2O5, Ti3O5, TiO2, ZiO2, Nb205, Ce02 and Si3N4.

7. Antireflection layer according to any of claims 1-6, wherein at least part of said nanoparticles has a spheroidal shape and/or wherein at least part of said nanoparticles has a cylindrical shape.

8. Multilayer structure, comprising at least one antireflection layer according to any of claims 1-7.

9. Optical element, preferably an optical lens or a display screen, comprising an antireflection layer according to any of claims 1-7.

10. Optoelectronic device, preferably a light-receiving or a light-emitting device, comprising an antireflection layer according to any of claims 1-7.

11. Optoelectronic device according to claim 10, wherein said antireflection layer is deposited onto a thin-film light absorbing or light-emitting layer.

12. Use of an array of nanoparticles as at least part of an antireflective coating, wherein the array of nanoparticles is disposed on a single thin-film dielectric spacer layer arranged on a substrate and wherein the dielectric spacer layer is interposed between the array of nanoparticles and the substrate,
wherein at least part of said nanoparticles are metallic nanoparticles, and
wherein the average dimensions of said nanoparticles are selected between approximately 100 and 300 nm and wherein the average distance between said particles is selected between approximately 200 and 700 nm, such that a surface coverage is provided between 10-20% of a surface area of the antireflection layer.

13. Use according to claim 12, wherein said metallic nanoparticles comprise a metal selected from the group of Au, Ag, Cu, Al and/or alloys thereof; and wherein the array of nanoparticles further comprises semiconducting particles and/or metal oxide particles, wherein at least part of said semiconducting nanoparticles comprises a semiconducting material being selected from the group IV semiconductors, the III-V or II-VI semiconducting compounds and/or combinations thereof; and/or wherein at least part of said metal oxide nanoparticles comprises a high-refractive index oxide selected from the group of Ta2O5, Ti3O5, TiO2, ZiO2, Nb205, Ce02 and Si3N4.

## Patentansprüche

1. Dünnfilm-Breitband-Antireflexionsschicht zur Verwendung mit einem optischen Element oder einer optoelektronischen Vorrichtung, umfassend:
mindestens eine auf einem Trägermaterial angeordnete dielektrische Dünnfilm-Abstandsschicht;
mindestens ein Array von Nanopartikeln, welches auf der dielektrischen Dünnfilm-Abstandsschicht angeordnet ist, wobei die dielektrische Abstandsschicht zwischen dem mindestens einen Array von Nanopartikeln und dem Trägermaterial angeordnet ist, wobei die Dielektrizitätskonstante der Nanopartikel im Wesentlichen von der Dielektrizitätskonstante der dielektrischen Abstandsschicht abweicht,
wobei mindestens ein Teil der Nanopartikel metallische Nanopartikel sind, und
wobei die durchschnittlichen Abmessungen der Nanopartikel zwischen etwa 100 und 300 nm gewählt sind, und wobei der durchschnittliche Abstand zwischen den Partikeln zwischen etwa 200 und 700 nm gewählt ist, sodass eine Oberflächeabdeckung zwischen 10 - 20 % einer Oberfläche der Antireflexionsschicht vorgesehen ist.

2. Antireflexionsschicht nach Anspruch 1, wobei die dielektrische Dünnfilm-Abstandsschicht Siliciumdioxid, Siliciumnitrid, Tetraethylorthosilicat (TEOS), ein organisches Harz, Polymer, einen Halbleiter und/oder Kombinationen davon umfasst.

3. Antireflexionsschicht nach Anspruch 1 oder 2, wobei die dielektrische Dünnfilm-Abstandsschicht eine Dicke etwa zwischen 10 und 300 nm, vorzugsweise zwischen 50 und 100 nm, aufweist.

4. Antireflexionsschicht nach einem der Ansprüche 1 - 3, wobei die metallischen Nanopartikel ein Metall umfassen, welches aus der Gruppe von Au, Ag, Cu, Al und/oder deren Legierungen gewählt ist.

5. Antireflexionsschicht nach einem der Ansprüche 1 - 3, wobei mindestens ein Teil der Nanopartikel halbleitende Nanopartikel sind, wobei vorzugsweise das Halbleitermaterial aus der Gruppe IV-Halbleiter, den III-V- oder II-VI-Halbleiterverbindungen und/oder Kombinationen davon gewählt ist.

6. Antireflexionsschicht nach einem der Ansprüche 1 - 3, wobei mindestens ein Teil der Nanopartikel Metalloxid-Nanopartikel sind, vorzugsweise hochrefraktive Indexoxide, welche aus der Gruppe Al₂O₃, Ta₂O₅, Ti₃O₅, TiO₂, ZiO₂, Nb₂O₅, CeO₂ und Si₃N₄ gewählt sind.

7. Antireflexionsschicht nach einem der Ansprüche 1 - 6, wobei mindestens ein Teil der Nanopartikel eine kugelförmige Form aufweisen und/oder wobei mindestens ein Teil der Nanopartikel eine zylindrische Form aufweisen.

8. Mehrschichtstruktur mit mindestens einer Antireflexionsschicht nach einem der Ansprüche 1 - 7.

9. Optisches Element, vorzugsweise eine optische Linse oder ein Bildschirm, mit einer Antireflexionsschicht nach einem der Ansprüche 1 - 7.

10. Optoelektronische Vorrichtung, vorzugsweise eine lichtsensitive oder eine lichtemittierende Vorrichtung, welche eine Antireflexionsschicht nach einem der Ansprüche 1 - 7 umfasst.

11. Optoelektronische Vorrichtung nach Anspruch 10, wobei die Antireflexionsschicht auf eine lichtabsorbierende oder lichtemittierende Dünnfilmschicht aufgebracht ist.

12. Verwendung eines Nanopartikel-Arrays zumindest als Teil einer Antireflexionsbeschichtung, wobei das Array aus Nanopartikeln auf einer einzigen, auf einem Trägermaterial angeordneten, dielektrischen Dünnfilm-Abstandsschicht angeordnet ist und wobei die dielektrische Abstandsschicht zwischen dem Nanopartikel-Array und dem Trägermaterial angeordnet ist,
wobei mindestens ein Teil der Nanopartikel metallische Nanopartikel sind, und
wobei die mittleren Abmessungen der Nanopartikel zwischen etwa 100 und 300 nm gewählt sind und wobei der mittlere Abstand zwischen den Partikeln zwischen etwa 200 und 700 nm gewählt ist, sodass eine Oberflächenabdeckung zwischen 10 - 20 % einer Oberfläche der Antireflexionsschicht vorgesehen ist.

13. Verwendung nach Anspruch 12, wobei die metallischen Nanopartikel ein Metall umfassen, welches aus der Gruppe Au, Ag, Cu, Al und/oder deren Legierungen gewählt ist; und wobei die Anordnung von Nanopartikeln weiterhin halbleitende Partikel und/oder Metalloxidpartikel umfasst, wobei mindestens ein Teil der halbleitenden Nanopartikel ein halbleitendes Material umfasst, welches aus den Halbleitern der Gruppe IV-Halbleiter, den III-V- oder II-VI-Halbleiterverbindungen und/oder Kombinationen davon gewählt ist; und/oder
wobei mindestens ein Teil der Metalloxid-Nanopartikel ein Oxid mit hohem refraktivem Index, welches aus der Gruppe Ta₂O₅, Ti₃O₅, EiO₂, ZiO₂, Nb₂O₅, CeO₂ und Si₃N₄ gewählt ist, umfasst.

## Revendications

1. Couche antireflet à large bande en film mince destinée à être utilisée avec un élément optique ou un dispositif optoélectronique, comprenant :
au moins une couche d'espacement diélectrique en film mince agencée sur un substrat ;
au moins un réseau de nanoparticules disposées sur ladite couche d'espacement diélectrique en film mince, la couche d'espacement diélectrique étant interposée entre le au moins un réseau de nanoparticules et le substrat, dans laquelle la constante diélectrique desdites nanoparticules est sensiblement distincte de la constante diélectrique de ladite couche d'espacement diélectrique,
dans laquelle au moins une partie desdites nanoparticules sont des nanoparticules métalliques, et
dans laquelle les dimensions moyennes desdites nanoparticules sont sélectionnées entre environ 100 et 300 nm et dans laquelle la distance moyenne entre lesdites particules est sélectionnée entre approximativement 200 et 700 nm de sorte qu'une couverture de surface est fournie entre 10-20 % d'une surface de la couche antireflet.

2. Couche antireflet selon la revendication 1, dans laquelle ladite couche d'espacement diélectrique en film mince comprend du dioxyde de silicium, du nitrure de silicium, du tétraéthylorthosilicate (TEOS), une résine organique, un polymère, un semi-conducteur et/ou des combinaisons de ceux-ci.

3. Couche antireflet selon les revendications 1 ou 2, dans laquelle ladite couche d'espacement diélectrique en film mince a une épaisseur comprise approximativement entre 10 et 300 nm, de préférence entre 50 et 100 nm.

4. Couche antireflet selon l'une quelconque des revendications 1 à 3, dans laquelle les nanoparticules métalliques comprennent un métal sélectionné dans le groupe comprenant Au, Ag, Cu, A1 et/ou des alliages de ceux-ci.

5. Couche antireflet selon l'une quelconque des revendications 1 à 3, dans laquelle au moins une partie desdites nanoparticules est constituée de nanoparticules semiconductrices, ledit matériau semiconducteur étant de préférence sélectionné parmi les semi-conducteurs du groupe IV, les composés semiconducteurs III-V ou II-VI et/ou des combinaisons de ceux-ci.

6. Couche antireflet selon l'une quelconque des revendications 1 à 3, dans laquelle au moins une partie desdites nanoparticules sont des nanoparticules d'oxyde métallique, de préférence des oxydes à indice de réfraction élevé sélectionnés dans le groupe comprenant Al2O3, Ta2O5, Ti3O5, TiO2, ZiO2, Nb205, Ce02 et Si3N4.

7. Couche antireflet selon l'une quelconque des revendications 1 à 6, dans laquelle au moins une partie desdites nanoparticules a une forme sphéroïde et/ou dans lequel au moins une partie desdites nanoparticules a une forme cylindrique.

8. Structure multicouche, comprenant au moins une couche antireflet selon l'une quelconque des revendications 1 à 7.

9. Elément optique, de préférence une lentille optique ou un écran d'affichage, comprenant une couche antireflet selon l'une quelconque des revendications 1 à 7.

10. Dispositif optoélectronique, de préférence un dispositif récepteur de lumière ou émetteur de lumière, comprenant une couche antireflet selon l'une quelconque des revendications 1 à 7.

11. Dispositif optoélectronique selon la revendication 10, dans lequel ladite couche antireflet est déposée sur une couche absorbant la lumière ou émettant de la lumière en film mince.

12. Utilisation d'un réseau de nanoparticules sous la forme d'au moins une partie d'un revêtement antireflet, dans laquelle le réseau de nanoparticules est disposé sur une couche d'espacement diélectrique en film mince unique disposée sur un substrat et dans laquelle la couche d'espacement diélectrique est interposée entre le réseau de nanoparticules et le substrat,
dans laquelle au moins une partie desdites nanoparticules sont des nanoparticules métalliques, et
dans laquelle les dimensions moyennes desdites nanoparticules sont sélectionnées entre environ 100 et 300 nm et dans laquelle la distance moyenne entre lesdites particules est sélectionnée entre approximativement 200 et 700 nm, de sorte qu'une couverture de surface est fournie, entre 10-20 % d'une surface de la couche antireflet.

13. Utilisation selon la revendication 12, dans laquelle lesdites nanoparticules métalliques comprennent un métal sélectionné dans le groupe comprenant Au, Ag, Cu, Al et/ou des alliages de ceux-ci ; et dans laquelle le réseau de nanoparticules comprend en outre des particules semi-conductrices et/ou des particules d'oxyde métallique, dans laquelle au moins une partie desdites nanoparticules semiconductrices comprend un matériau semiconducteur sélectionné parmi les semi-conducteurs du groupe IV, les composés semiconducteurs III-V ou II-VI et/ou des combinaisons de ceux-ci ; et/ou dans laquelle au moins une partie desdites nanoparticules d'oxyde métallique comprennent un oxyde à indice de réfraction élevé sélectionné dans le groupe comprenant Ta2O5, Ti3O5, TiO2, ZiO2, Nb205, Ce02 et Si3N4.
